# EUROPEAN PATENT SPECIFICATION

(11) **EP 3 425 755 B1**
(45) Date of publication and mention of the grant of the patent: **09.08.2023**
(21) Application number: 17759848.9
(22) Date of filing: 24.02.2017
(51) Int. Cl.: H01S 5/183, H01S 5/026, H01S 5/40, H01S 5/42, H01S 5/50

(54) **SURFACE LIGHT EMITTING LASER**
OBERFLÄCHENLICHTEMITTIERENDER LASER
UNITÉ D'ÉMISSION DE LUMIÈRE DE SURFACE

(30) Priority: 29.02.2016 JP 2016037272
(43) Date of publication of application: 09.01.2019
(73) Proprietor: Tokyo Institute of Technology, Tokyo 152-8550 (JP)
(72) Inventor: KOYAMA, Fumio, Tokyo 152-8550 (JP); NAKAHAMA, Masanori, Tokyo 152-8550 (JP); GU, Xiaodong, Tokyo 152-8550 (JP)
(74) Representative: Schröer, Gernot H.
(86) International application number: PCT/JP2017/007164
(87) International publication number: WO 2017/150382

(56) References cited:
- JP-A- 2012 049 180
- JP-A- 2013 045 803
- JP-A- 2015 032 801
- US-A1- 2004 012 845
- TOSHIKAZU SHIMADA ET AL: "Slow light amplifier laterally integrated with VCSEL", MICROOPICS CONFERENCE (MOC), 2011 17TH, IEEE, 30 October 2011 (2011-10-30), pages 1-2, XP032078457, ISBN: 978-1-4577-1344-6
- AHMED MOUSTAFA ET AL: "Application of strong slow-light feedback to boost the modulation bandwidth of VCSELs beyond 70 GHz", 2015 CONFERENCE ON LASERS AND ELECTRO-OPTICS (CLEO), OSA, 10 May 2015 (2015-05-10), pages 1-2, XP033194175, DOI: 10.1364/CLEO_SI.2015.SM3F.6 [retrieved on 2015-08-10]
- MASANORI NAKAHAMA ET AL: "On-Chip High-Resolution Beam Scanner Based on Bragg Reflector Slow-Light Waveguide Amplifier and Tunable Micro-Electro-Mechanical System Vertical Cavity Surface Emitting Laser", JAPANESE JOURNAL OF APPLIED PHYSICS, JAPAN SOCIETY OF APPLIED PHYSICS, JP, vol. 51, no. 4.1, 1 April 2012 (2012-04-01), pages 40208-1, XP001576425, ISSN: 0021-4922, DOI: 10.1143/JJAP.51.040208 [retrieved on 2012-03-27]
- NAKAHAMA M ET AL: "Slow light VCSEL amplifier for high-resolution beam steering and high-power operations", 2016 CONFERENCE ON LASERS AND ELECTRO-OPTICS (CLEO), OSA, 5 June 2016 (2016-06-05), pages 1-2, XP033025492, [retrieved on 2016-12-16]

## Description

### [TECHNICAL FIELD]

The present invention relates to a surface-emitting semiconductor laser, and particularly to a surface-emitting semiconductor laser with increased high-power output.

### [BACKGROUND ART]

With conventional surface-emitting lasers, increasing the single-wavelength output has been limited to the mW level. If such a surface-emitting laser could be improved to be capable of providing watt-class high-power output, this would allow various kinds of applications to be developed. Examples of such applications include: wavelength scanning light sources for optical coherence tomography (OCT); light sources for medium-to-long-distance optical communication; laser radar (LIDAR) light sources to be mounted on a vehicle, drone, robot, or the like; monitoring systems; automatic inspection apparatuses employed at a manufacturing site; laser dryers employed in a printer; etc.

### [Non-patent Documents]

[Non-patent document 1]
   A. Haglund, "Single Fundamental-Mode Output Power Exceeding 6 mW From VCSELs With a Shallow Surface Relief," IEEE PHOTONICS TECHNOLOGY LETTERS, VOL. 16, NO. 2, FEBRUARY 2004.
[Non-patent document 2]
   Jean-Francois Seurin et al., "High-power vertical-cavity surface-emitting lasers for solid-state laser pumping," Vertical-Cavity Surface-Emitting Lasers XVI, edited by Chun Lei, Kent D. Choquette, Proc. of SPIE Vol. 8276, 2012.
[Non-patent document 3]
   Kazuyoshi Hirose, et. al., "Watt-class high-power, high-beam-quality photonic-crystal lasers," NATURE PHOTONICS, VOL 8, p.406 MAY 2014.
[Non-patent document 4]
   Toshikazu Shimada, et. al., "Lateral integration of vertical-cavity surface-emitting laser and slow light Bragg reflector waveguide devices," APPLIED OPTICS, Vol. 53, No. 9, p.1766, March 2014.
[Non-patent document 5]
   M. Nakahama, "Lateral integration of MEMS VCSEL and slow light amplifier boosting single mode power," IEICE ELEX, vol. 9, no.6, pp.544-551, 2012.
[Non-patent document 6
   TOSHIKAZU SHIMADA ET AL: "Slow light amplifier laterally integrated with VCSEL",MICROOPICS CONFERENCE (MOC), 2011 17TH, IEEE, 30 October 2011 (2011-10-30).

This non-patent document discloses surface-emitting laser comprising: an output unit having an oblong-shaped VCSEL structure; and a driving circuit structured to inject a current into the VCSEL structure so as to maintain an oscillation state, wherein the output unit is structured such that a coherent seed light is received via one end of the VCSEL structure in a longitudinal direction, such that the seed light propagates as a slow light through the VCSEL structure in a longitudinal direction while being reflected multiple times in the VCSEL structure in a vertical direction, and such that an output light is extracted from an upper surface of the VCSEL structure.

### [DISCLOSURE OF THE INVENTION]

### [PROBLEM TO BE SOLVED BY THE INVENTION]

In order to provide a surface-emitting laser with such high output, a surface-machined structure designed to suppress high-order mode oscillation has been proposed (Non-patent document 1). However, there is a limit to increasing the area size up to 10 micrometers or less, and such an arrangement is not capable of providing an output exceeding 10 mW. In a case of employing an array structure (Non-patent document 2) in which a great number of surface-emitting lasers are two-dimensionally integrated, such an arrangement is capable of providing high output of 10 W or more. However, individual elements cannot be configured with a uniform phase and uniform wavelength. This leads to a problem of a wide oscillation spectrum width, a problem of a large beam divergence angle, and a problem in that such a beam cannot be focused even if a lens is used.

In a case in which a surface-emitting laser is configured using a two-dimensional photonic crystal (Non-patent document 3), such an arrangement supports watt-class high-power output and a high-quality beam. However, such an arrangement requires a semiconductor to have a fine cyclic structure as its internal structure, which is a problem from the viewpoint of manufacturing and reliability.

In order to solve such problems, the present inventors have proposed a surface-emitting laser with a light amplification function having a structure in which a VCSEL (vertical-cavity surface-emitting laser) and a slow light SOA (semiconductor optical amplifier) are arranged in the lateral direction of a substrate (Non-patent documents 4 and 5). Such a surface-emitting laser described in Non-patent document 4 provides a maximum light output of 6 mW, and is not capable of providing watt-class output.

The present invention has been made in view of such a situation. Accordingly, it is an exemplary purpose of an embodiment of the present invention to provide a surface-emitting laser with high-power output.

### [MEANS TO SOLVE THE PROBLEM]

The present invention relates to a surface-emitting laser defined in independent claim 1.

It should be noted that, in the present specification, for convenience, the up-and-down direction, the horizontal direction, and the vertical direction are defined independent of the directions defined in the actual operation.

The output unit having the VCSEL structure is operated as an amplifier that amplifies a seed light externally input in a state in which the output unit having the VCSEL structure is laser-oscillated. This allows high-power output to be provided.

In the oscillation state, the wavelength λ1 of the seed light and the wavelength λ2 provided by the VCSEL structure of the output unit is designed to satisfy a relation λ1 ≠ λ2. This arrangement is capable of preventing the light coupled with the end (coupling end) of the output unit from being emitted again via the coupling end.

Also, a seed light source structured to generate the seed light and the output unit may be integrated adjacent to each other in the longitudinal direction such that they share the VCSEL structure. This allows the surface-emitting laser to be manufactured with a further reduced size and a further reduced cost.

Also, the wavelength λ1 of the seed light and the oscillation wavelength λ2 provided by the VCSEL structure may be designed to satisfy a relation λ1 < λ2. This improves a function (isolation) for suppressing the occurrence of return light that propagates from the output unit to the seed light source. This provides improved beam quality.

Also, the VCSEL structure of the seed light source and the output unit may comprises an air gap layer. Also, the air gap layer on the seed light source side may be structured to have a variable thickness that can be controlled by means of a micromachined structure. This provides the relation λ1 < λ2.

The VCSEL structure of the seed light source and the output unit may be structured such that there is a difference between the number of layers between the seed light source side and the output unit side. More specifically, an upper DBR (Distributed Bragg Reflector) of the VCSEL structure of the output unit may be structured to have a greater number of layers than those of the upper DBR of the VCSEL structure of the seed light source. This provides the relation λ1 < λ2.

Also, the VCSEL structure of the seed light source may comprise a low-refractive-index layer. This provides the relation λ1 < λ2.

Also, the seed light source may have a coupled resonance structure. This provides the relation λ1 < λ2.

Also, the output unit may be formed such that it is bent in a zig-zag manner. This arrangement requires only a further reduced area to provide higher-power output.

Also, an optical confinement layer that forms the active-layer VCSEL structure may be structured to have a refractive index that is smaller than an average refractive index of the upper DBR and the lower DBR. This arrangement is capable of cutting off the waveguide mode due to total reflection.

Preferred embodiments of the present invention are defined in the dependent claims.

### [ADVANTAGE OF THE PRESENT INVENTION]

With an embodiment of the present invention, such an arrangement supports at least one from among high beam quality, narrow spectrum width, and high-power output.

### [BRIEF DESCRIPTION OF THE DRAWINGS]

Fig. 1 is a cross-sectional diagram showing a surface emitting laser according to an embodiment;
Fig. 2 is a diagram showing input/output characteristics of an output unit of the surface emitting laser shown in Fig. 1;
Fig. 3 is a diagram showing a measurement system employed in an experiment;
Fig. 4A is a diagram showing amplification characteristics of the output unit, Fig. 4B is a diagram showing a spectrum of the output light, and Fig. 4C is a diagram showing the beam angle and the beam width;
Fig. 5 is a diagram showing results of simulation of the amplification characteristics of the output unit;
Fig. 6 is a cross-sectional diagram showing a surface emitting laser according to a first embodiment;
Fig. 7 is a cross-sectional diagram showing a surface emitting laser according to a second embodiment;
Fig. 8 is a cross-sectional diagram showing a surface emitting laser according to a third embodiment;
Fig. 9 is a plan view showing a surface emitting laser according to a fourth embodiment;
Fig. 10 is a layout diagram showing a surface emitting laser according to a fifth embodiment;
Fig. 11 is a cross-sectional diagram showing a surface emitting laser according to a sixth embodiment;
Figs. 12A and 12B are diagrams each showing results of simulation of the surface-emitting laser shown in Fig. 11; and
Fig. 13 is a diagram showing results of simulation of the surface-emitting laser shown in Fig. 11.

### [BEST MODE FOR CARRYING OUT THE INVENTION]

Description will be made below regarding the present invention based on preferred embodiments with reference to the drawings. The same or similar components, members, and processes are denoted by the same reference numerals, and redundant description thereof will be omitted as appropriate. The embodiments have been described for exemplary purposes only, and are by no means intended to restrict the present invention. Also, it is not necessarily essential for the present invention that all the features or a combination thereof be provided as described in the embodiments.

### OUTLINE

First, description will be made regarding an outline of a surface-emitting laser according to an embodiment. The surface-emitting laser includes an output unit having an oblong-shaped VCSEL (vertical-cavity surface-emitting laser) structure. The output unit operates in an oscillation state in which a current that is larger than an oscillation threshold value is injected. The output unit receives coherent seed light at one end of the VCSEL structure in the longitudinal direction. With the output unit, the light propagates as slow light in the longitudinal direction of the VCSEL structure while being reflected multiple times in the vertical direction. The output light is extracted via an upper surface of the VCSEL structure.

With the surface-emitting laser, by maintaining an oscillation state, such an arrangement is capable of providing high-efficiency optical amplification, thereby providing high-power output. Furthermore, by inputting coherent light having a single wavelength and uniform wavefronts as the seed light, this arrangement is capable of providing high-beam-quality output light having high-power output and uniform wavefronts.

### EMBODIMENTS

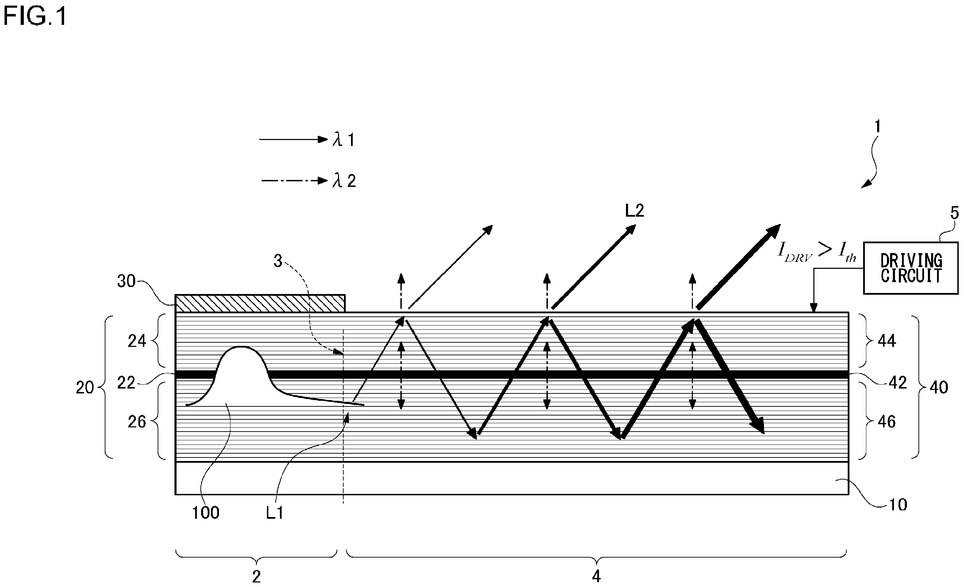

Fig. 1 is a cross-sectional diagram showing a surface-emitting laser 1 according to an embodiment. The surface-emitting laser 1 has a structure in which a first surface-emitting laser (which will be referred to as the "seed light source 2" hereafter) and a second surface-emitting laser (which will be referred to as the "output unit 4" hereafter) are arranged in a lateral direction on a single semiconductor substrate. As described in the outline, the output unit 4 has an oblong-shaped VCSEL (vertical-cavity surface-emitting laser) structure 40. The output unit 4 may be designed to have a length on the order of 1000 times the length of the seed light source 2. The VCSEL structure 40 includes a lower DBR (Distributed Bragg Reflector) 26, an active layer 42, and an upper DBR 44.

The seed light source 2 has the same VCSEL structure 20 as that of the output unit 4. The seed light source 2 generates a coherent seed light L1. In the internal structure of the seed light source 2, the light is amplified by means of stimulated emission while being repeatedly reflected in the vertical direction. A part of the amplified light is coupled as the seed light L1 with one end (coupling surface 3) of the VCSEL structure of the adjacent output unit 4 in the longitudinal direction.

Specifically, the VCSEL structure 20 of the seed light source 2 includes the lower DBR 26, an active layer 22, and the upper DBR 24 formed on a semiconductor substrate 10. In order to provide an upper mirror of a vertical oscillator of the VCSEL structure 20 with a reflection ratio that is close to 100%, a high-reflection mirror 30 is preferably formed on the upper surface of the upper DBR 24. The high-reflection mirror 30 is preferably formed of a metal material such as gold (Au) or the like or otherwise is preferably configured as a dielectric multilayer film mirror.

A driving circuit 5 injects a current I_{DRV} that is larger than an oscillation threshold value I_{TH} into the VCSEL structure 40 of the output unit 4 so as to operate the output unit 4 in an oscillation state. The output unit 4 receives the seed light L1 via its coupling surface 3. The seed light L1 propagates as a slow light in the longitudinal direction of the VCSEL structure 40 while being reflected multiple times in the vertical direction within the VCSEL structure. An output light L2 is extracted via the upper surface of the VCSEL structure 40. The upper reflecting face of a cavity of the output unit 4, i.e., the upper DBR 44 may be designed to have a reflection ratio on the order of 95% to 99%, for example.

If return light from the output unit 4 to the seed light source 2 occurs, this leads to mode disturbance in the seed light source 2. This leads to degraded beam quality of the seed light L1, resulting in degraded quality of the output light L2. Accordingly, the wavelength λ1 of the seed light L1 and the oscillation wavelength λ2 to be provided by the VCSEL structure of the output unit 4 are preferably designed such that the relation λ1 ≠ λ2 holds true. In particular, in a case of employing the structure as shown in Fig. 1 in which the seed light source 2 and the output unit 4 are laterally integrated, the wavelengths are preferably designed such that the relation λ1 ≠ λ2 holds true. This arrangement suppresses the occurrence of return light that propagates from the output unit 4 to the seed light source 2, thereby providing improved beam quality.

The above is the basic structure of the surface-emitting laser 1. Next, specific description will be made regarding several example configurations. The VCSEL structure and the materials may be designed using known techniques. Such an arrangement is not restricted in particular. Description will be made regarding an example thereof. For example, the semiconductor substrate 10 may be configured as a III-V family semiconductor substrate. Specifically, the semiconductor substrate 10 may be configured as a GaAs substrate. An n-side electrode (not shown) is formed on the back face of the semiconductor substrate 10. The lower DBR 26(46) has a layered structure in which an Al_{0.92}Ga_{0.08}As layer and an Al_{0.16}Ga_{0.84}As layer (AlGaAs is aluminum gallium arsenide), each of which has been doped with silicon as an n-type dopant, are alternately and repeatedly layered, which provides a reflection ratio in the vicinity of 100%.

The active layer 22(42) has a multiple quantum well structure comprising In_{0.2}Ga_{0.8}As/GaAs (indium gallium arsenide/gallium arsenide) layers. The active layer 22(42) may have a triple quantum well structure, for example. Furthermore, a lower spacer layer and an upper spacer layer, each of which is configured as an undoped Al_{0.3}Ga_{0.7}As layer, may be provided to both faces of the multiple quantum well structure, as necessary. The upper DBR 24(44) has a layered structure in which carbon-doped Al_{0.92}Ga_{0.08}As layers and Al_{0.16}Ga_{0.84}As layers (AlGaAs is aluminum gallium arsenide) are alternately and repeatedly layered.

Next, description will be made regarding the operation of the surface-emitting laser 1 shown in Fig. 1. When the seed light source 2 is oscillated, the seed light source 2 generates a light intensity distribution as indicated by reference numeral 100. A part of the light thus generated is emitted toward the output unit 4 side as the seed light L1. On the other hand, a current I that is larger than a threshold current I_{TH} is injected into the output unit 4. Accordingly, the output unit 4 also comes to be in an oscillation state. When the seed light L1 is not coupled, as indicated by the line of alternately long and short dashes, spontaneous emission light generated by the output unit 4 and stimulated emission light generated based on the spontaneous emission light as a seed light are amplified while being reflected in the vertical direction. As a result, light L3 having a wavelength λ2 is emitted.

With the surface-emitting laser 1 shown in Fig. 1, instead of spontaneous emission light, oscillation with the seed light L1 as a seed coupled with the coupling surface 3 of the output unit 4 becomes dominant. Accordingly, the oscillation of the light L3 having the wavelength λ2 is suppressed. Furthermore, as shown in the drawing, the seed light L1 is amplified while being reflected multiple times in the vertical direction and propagating as a slow light toward the right side. The light L2 thus amplified is output from the upper surface of the output unit 4.

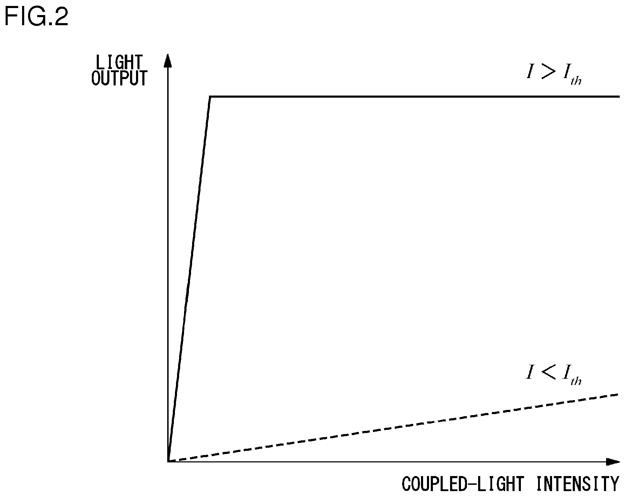

Fig. 2 is a diagram showing the input/output characteristics of the output unit 4 of the surface-emitting laser 1 shown in Fig. 1. The horizontal axis represents the intensity of the coupled light, i.e., the intensity of the seed light L1. The vertical axis represents the light output of the surface-emitting laser 1. As a comparison, the amplification characteristics provided by a conventional technique (Non-patent documents 4 and 5) are indicated by the dotted line. With conventional techniques, in order to provide the output light in proportion to the coupled light, a current that is smaller than the threshold current I_{TH} is supplied to the slow light SOA. This limits the output light to a small level. In contrast, with the present embodiment, the output unit 4 is oscillated so as to provide a saturated gain with respect to the coupled-light intensity, thereby providing a high-power output operation.

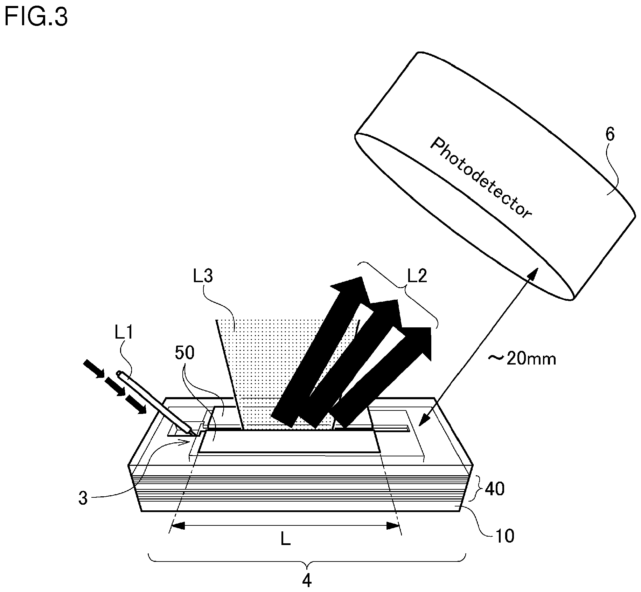

In order to verify the amplification characteristics of the surface-emitting laser 1, only the output unit 4, which is a part of the surface-emitting laser 1, was manufactured, and the output characteristics thereof were measured. Fig. 3 is a diagram showing a measurement system employed in the experiment. Electrodes 50 are formed on the upper surface of the output unit 4 in order to allow a current to be injected. The seed light L1 received from a light source configured as an external component of the output unit 4 is input with an appropriate incident angle to the coupling surface 3 of the output unit 4. In the experiment, the seed light L1 was coupled with the output unit 4 via an optical fiber. The output light L2 is measured by means of a photodetector 6. A region interposed between the electrodes 50, which is a part of the output unit 4, contributes to amplification. The output unit 4 was manufactured to have a length L of 1 mm in the horizontal direction. The output angle of the output light L2 depends on the wavelength λ1 of the seed light L1. The output unit 4 provides an oscillation waveform λ2 of 980 nm.

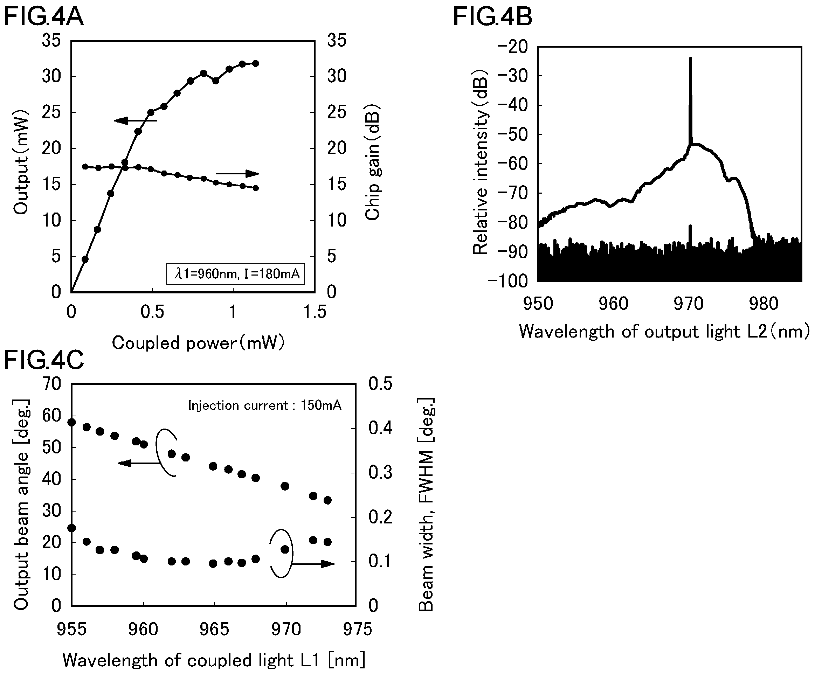

Fig. 4A is a diagram showing the amplification characteristics of the output unit 4. Fig. 4B is a diagram showing the spectrum of the output light L2. Fig. 4C is a diagram showing the beam angle and the beam width. Figs. 4A through 4C show the respective measurement results.

In Fig. 4A, the horizontal axis represents the intensity of the coupled light (seed light) L1, and the vertical axis represents the intensity of the output light L2. Here, an injection current of 180 mA is injected. Based on the gain saturation characteristics the output unit 4 operates in an oscillation state. This arrangement is capable of acquiring the output light L2 exceeding 30 mW for a coupled light intensity of 1 mW. That is to say, this arrangement is capable of providing dramatically increased high-power output as compared with similar arrangements according to conventional techniques.

As shown in Fig. 4B, it has been confirmed that the output light L2 has a single wavelength with a narrow spectrum width. Furthermore, as shown in Fig. 4C, this arrangement is capable of providing high beam quality with a beam width on the order of 0.1 degrees without involving an optical system such as a lens configured to focus the output light L2.

As described above, it has been confirmed from the experimental results that the surface-emitting laser 1 including the output unit 4 configured to operate in an oscillation state is advantageous.

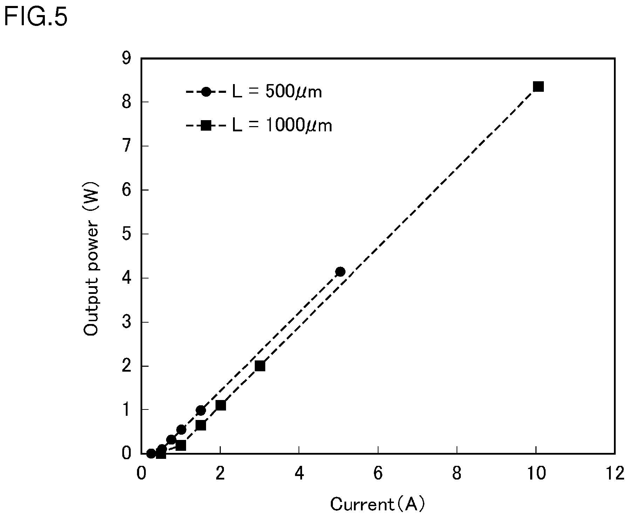

Fig. 5 is a diagram showing simulation results of the amplification characteristics of the output unit 4. The simulation results were calculated for an output unit 4 having a horizontal length L of 500 µm and an output unit 4 having a horizontal length L of 1000 µm. Furthermore, it is assumed that the radiation loss αᵣ toward the upper side of the output unit 4 = 200 cm⁻¹, the coupled light intensity = 1 mW, the number of well layers of the active region = 5, the waveguide width of the output unit 4 = 10 µm, and the optical confinement factor Γ = 6.36%. In this case, it can be understood that such an arrangement provides a high-power output operation of 8 W or more using an injection current of 10 A.

In the above-described experiment, it has been confirmed that such an arrangement provides an output of several dozen mW using an injection current on the order of 100 mA. However, it can be confirmed based on the simulation results that, by injecting a current of 1 A or more, this arrangement is capable of providing an output of several W.

Next, specific description will be made regarding an arrangement including the seed light source 2 and the output unit 4 having the same VCSEL structure 20 (40) that provides the relation λ1 < λ2.

### FIRST EMBODIMENT

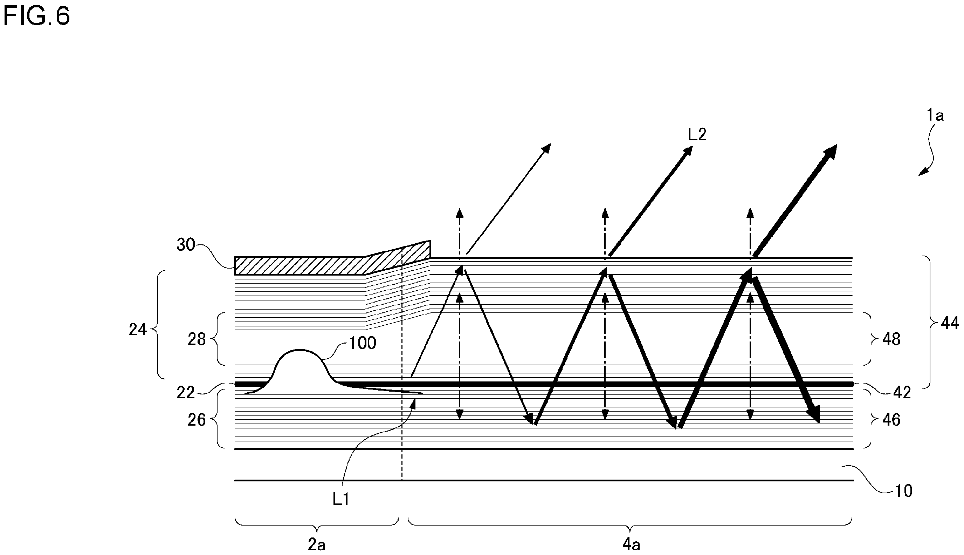

Fig. 6 is a cross-sectional diagram showing a surface-emitting laser 1a according to a first embodiment. In the surface-emitting laser 1a, the VCSEL structures 20 and 40 of a seed light source 2a and an output unit 4a include respective air gap layers 28 and 48. The air gap layer 28 of the seed light source 2a side is configured to have a variable thickness that can be controlled by means of a micromachined structure, i.e., a MEMS (Micro-ElectroMechanical Systems) structure. By changing the thickness of the air gap layer 28, the position of the high-reflection mirror 30 can be controlled. This allows the cavity length of the seed light source 2a to be changed, thereby allowing the oscillation wavelength λ1 to be reduced. It should be noted that, in the subsequent drawings, the driving circuit 5 is not shown.

### SECOND EMBODIMENT

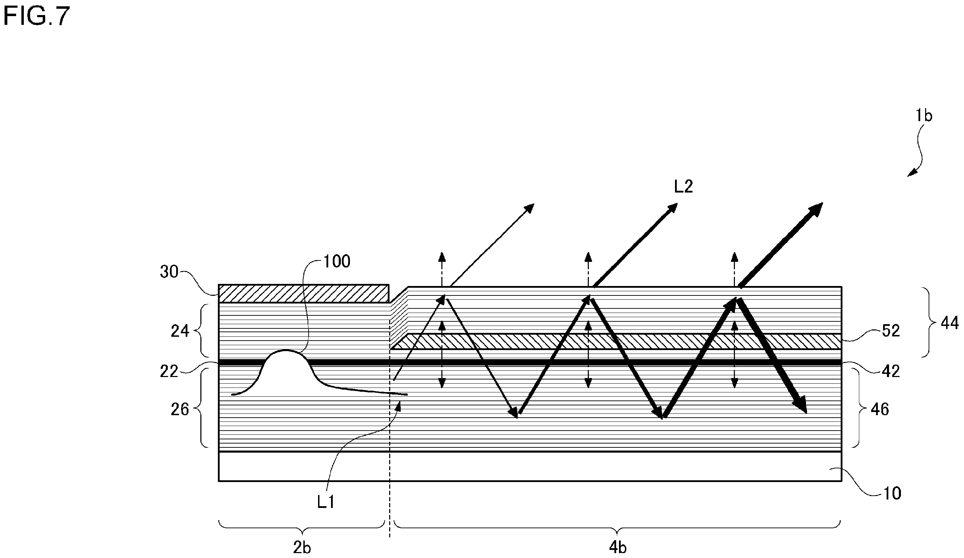

Fig. 7 is a cross-sectional diagram showing a surface-emitting laser 1b according to a second embodiment. In the surface-emitting laser 1b, the number of layers that form the upper DBR 44 of the output unit 4b having the VCSEL structure 40 may be larger than that of the upper DBR 24 of the seed light source 2b having the VCSEL structure. The difference between the upper DBR 44 and the upper DBR 24 is represented by a phase control layer 52. The phase control layer 52 may be formed by means of selective growth. With the second embodiment, by increasing the cavity length of the output unit 4b, this arrangement is capable of providing the relation λ1 < λ2.

### THIRD EMBODIMENT

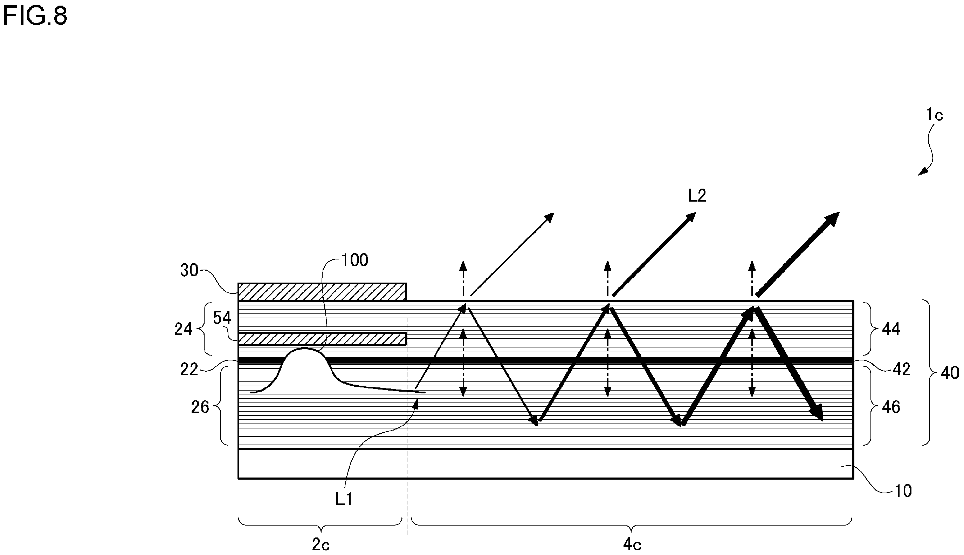

Fig. 8 is a cross-sectional diagram showing a surface-emitting laser 1c according to a third embodiment. In the surface-emitting laser 1c, the seed light source 2c has a VCSEL structure 20 including a low-refractive-index layer 54. The low-refractive-index layer 54 is a part of the upper DBR 24, which can be formed by means of selective oxidation. By forming a part of the layers that form the upper DBR 24 with a low refractive index, this arrangement allows the effective cavity length of the seed light source 2c to be reduced, thereby providing the relation λ1 < λ2.

### FOURTH EMBODIMENT

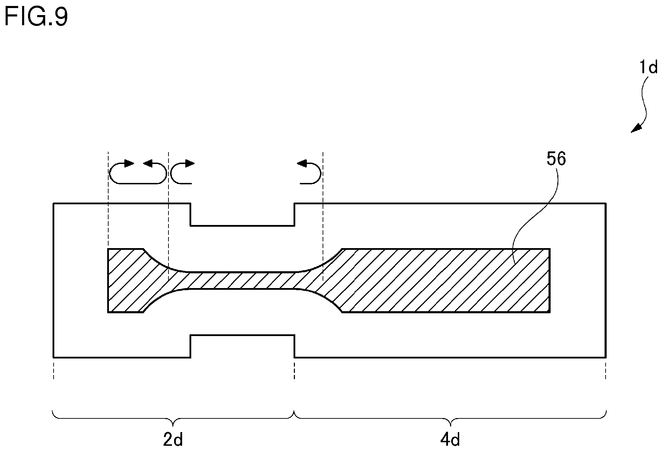

Fig. 9 is a plan view showing a surface-emitting laser 1d according to a fourth embodiment. In the surface-emitting laser 1d, the seed light source 2d has a coupled resonator structure. The coupled resonator can be designed by designing the shape of an oxidation opening 56. By controlling the interference conditions of the coupled resonator, and specifically, by providing a difference in the FSR (free spectrum range) between the two resonators, this arrangement is capable of modulating the wavelength provided by the seed light source 2d (Vernier effect), thereby providing the relation λ1 < λ2.

### FIFTH EMBODIMENT

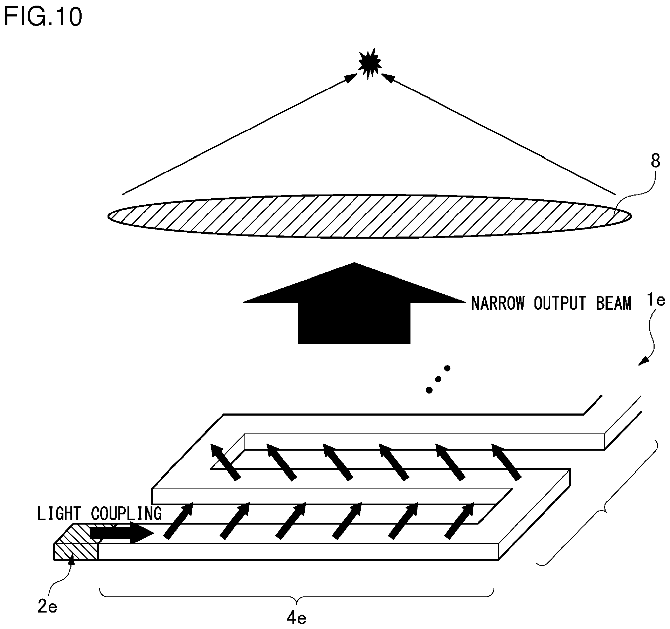

As shown in Fig. 5, as the length L of the output unit 4 in the horizontal direction is increased, the output that can be extracted becomes higher. Fig. 10 is a layout diagram showing a surface-emitting laser 1e according to a fifth embodiment. An output unit 4e is laid out in a two-dimensional form. For example, the output unit 4e is configured in a zig-zag form, thereby providing an increase in the length L. As shown in Fig. 4C, this arrangement allows the output light L2 with a very small divergence angle to be output from the output unit 4e. Accordingly, by configuring the output unit 4e in a two-dimensional form, this arrangement is capable of generating a high-power output beam with a narrow divergence angle in a two-dimensional manner. Such a beam can be focused by means of an optical system 8 such as a lens, mirror, or the like, such that it is narrowed up to the diffraction limit. Such an arrangement can be expected to have many uses.

### SIXTH EMBODIMENT

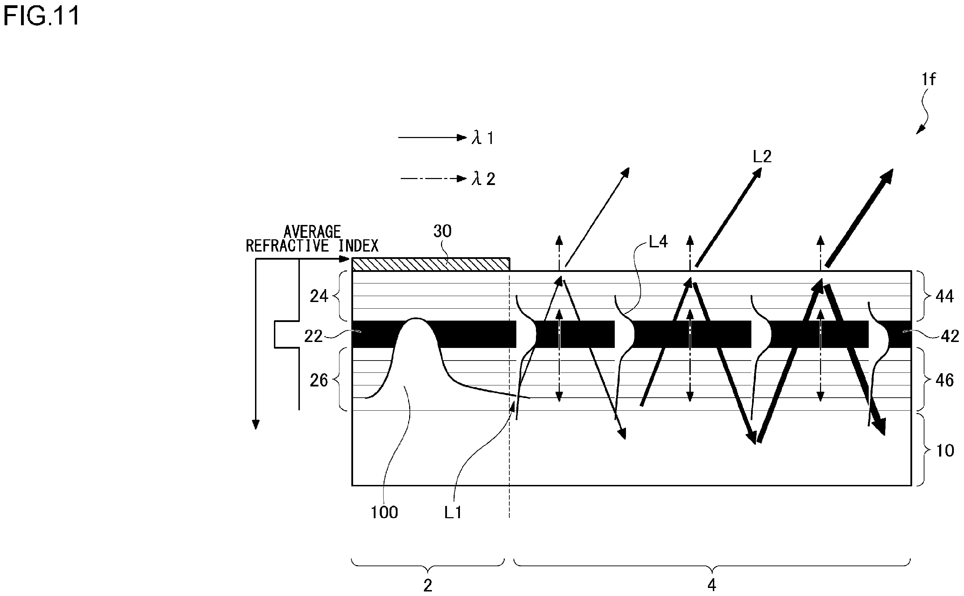

Fig. 11 is a cross-sectional diagram showing a structure of a surface-emitting laser 1f according to a sixth embodiment. In this embodiment, the optical confinement layer that forms the active layer 42 has a refractive index that is smaller than the average refractive index of those of the upper DBR layer 44 and the lower DBR layer 46. This arrangement is capable of cutting off the waveguide mode due to total reflection. By cutting off the waveguide mode, this arrangement is capable of suppressing parasitic oscillation in the horizontal direction due to the waveguide mode or suppressing energy consumption due to the growth of the amplified spontaneous emission light L₄. As a result, by increasing the length of the surface-emitting laser, this arrangement allows the output light from the surface-emitting laser to be increased.

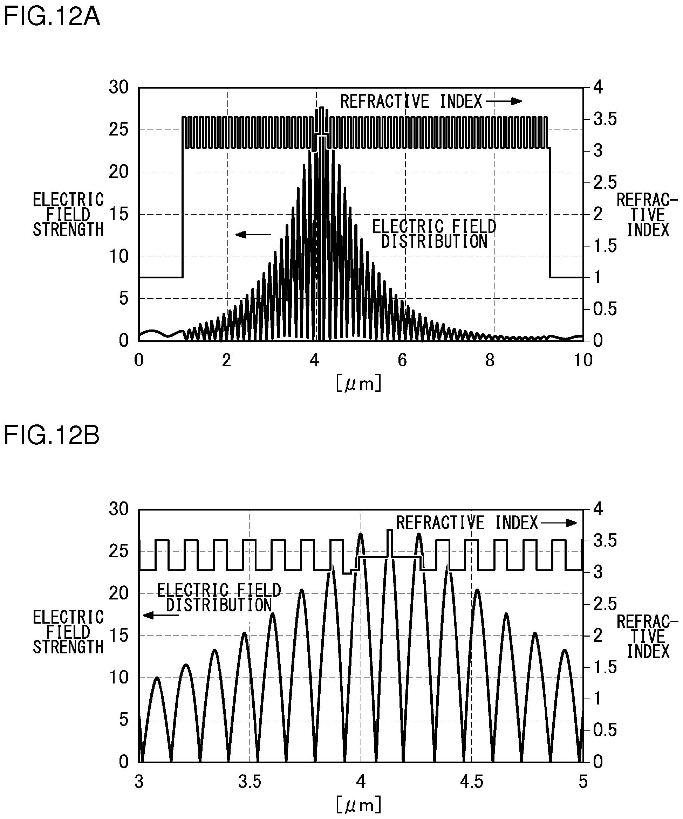

Figs. 12A and 12B are diagrams each showing a refractive index distribution and an electric field distribution provided by the surface-emitting laser shown in Fig. 11. Fig. 12B is an enlarged view of Fig. 12A. In Figs. 12A and 12B, the horizontal axis represents the relative position in the layered direction.

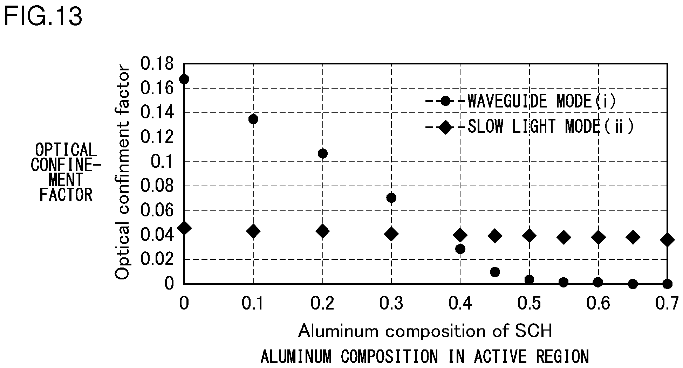

Fig. 13 is a diagram showing results of simulation of the optical confinement factor of the surface-emitting laser shown in Fig. 11. The horizontal axis represents the Al composition of the active region. The vertical axis represents the optical confinement factor. The optical confinement factor was calculated for (i) the light in the waveguide mode, and (ii) the light in the slow light mode.

By configuring the optical confinement layer to have a refractive index that is lower than the average refractive index of those of the upper DBR and the lower DBR, this arrangement is capable of cutting off the waveguide mode due to total reflection. For example, the simulation results show that, by configuring the optical confinement layer with an Al composition on the other of 0.55, this arrangement provides an optical confinement factor of almost zero in the waveguide mode. Furthermore, this arrangement allows the optical confinement factor to be maintained at a constant value of 4% (0.04) with respect to the seed light. This allows the amplified spontaneous emission light due to the waveguide mode to be suppressed, and allows the seed light to be amplified.

### SEVENTH EMBODIMENT

The seed light source 2 and the output unit 4 are not necessarily required to be integrated. Also, as shown in Fig. 3, the seed light source 2 and the output unit 4 may be configured as separate components.

Description has been made regarding the present invention with reference to the embodiments using specific terms. However, various modifications and various changes in the layout can be made without departing from the scope of the present invention defined in appended claims.

### [DESCRIPTION OF THE REFERENCE NUMERALS]

1 surface-emitting laser, 2 seed light source, 4 output unit, 5 driving circuit, 6 photodetector, 8 optical system, 10 semiconductor substrate, 20 VCSEL structure, 22 active layer, 24 upper DBR, 26 lower DBR, 28 air gap layer, 30 high-reflection mirror, 40 VCSEL structure, 42 active layer, 44 upper DBR, 46 lower DBR, 48 air gap layer, 50 electrode, 52 phase control layer, 54 low-refractive-index layer, L1 seed light, L2 output light.

### [INDUSTRIAL APPLICABILITY]

The present invention is applicable to a laser apparatus.

## Claims

1. A surface-emitting laser (1) comprising:
an output unit (4) having an oblong-shaped VCSEL, vertical-cavity surface-emitting laser, structure (40) including a lower DBR, Distributing Bragg Reflector, (46), an active layer (42), and an upper DBR (44); and
a driving circuit (5) structured to inject a current that is larger than an oscillation threshold value into the VCSEL structure (40) so as to maintain an oscillation state based on gain saturation of the VCSEL,
wherein the output unit (4) is structured to receive a coherent seed light (L1) at its one end (3) of the VCSEL structure (40), such that the seed light (L1) propagates as a slow light through the VCSEL structure (40) in a longitudinal direction while being reflected multiple times in the VCSEL structure (40) in a vertical direction, and such that an output light (L2) is extracted from an upper surface of the VCSEL structure (40), wherein a wavelength λ1 of the seed light (L1) and a wavelength λ2 provided by the VCSEL structure (40) of the output unit (4) satisfy a relation λ1 ≠ λ2.

2. The surface-emitting laser (1) according to claim 1, wherein a seed light source (2) structured to generate the seed light (L1) and the output unit (4) are integrated adjacent to each other in the longitudinal direction, wherein the seed light source (2) has a VCSEL structure (20) including a lower DBR (26), an active layer (22), and an upper DBR (24), and wherein the active layer (22) of the seed light source (2) and the active lacer (42) of the output unit (4) are sucessively formed.

3. The surface-emitting laser (1) according to claim 2, wherein a wavelength λ1 of the seed light (L1) and a wavelength λ2 provided by the VCSEL structure (40) of the output unit (4) satisfy a relation λ1 < λ2.

4. The surface-emitting laser (1) according to claim 2 or 3, wherein the VCSEL structure (20,40) of the seed light source (2) and the output unit (4) comprises an air gap layer,
and wherein the air gap layer on the seed light source side is structured to have a variable thickness that can be controlled by means of a micromachined structure.

5. The surface-emitting laser (1) according to claim 2 or 3, wherein the upper DBR (44) of the VCSEL structure (40) of the output unit (4) is structured to have a greater number of layers than those of the upper DBR (24) of the VCSEL structure (20) of the seed light source (2) .

6. The surface-emitting laser (1) according to claim 2 or 3, wherein a part of the layers that form the upper DBR (24) of the VCSEL structure (20) of the seed light source (2) are formed with a low refractive index such that the effective cavity length of the seed light source (20) is reduced to provide the relation λ₁ < λ₂ for the wavelength λ₁ of the seed light (L1) and the wavelength λ₂ provided by the VCSEL structure (40) of the output unit (4).

7. The surface-emitting laser (1) according to claim 2 or 3, wherein the seed light source (2) has a coupled resonance structure.

8. The surface-emitting laser (1) according to any one of claims 1 through 7, wherein the output unit (4) is formed such that it is bent in a zig-zag manner.

9. The surface-emitting laser (1) according to claim 1, wherein an optical confinement layer that forms the active-layer (42) of the VCSEL structure (40) is structured to have a refractive index that is smaller than an average refractive index of the upper DBR (44) and the lower DBR (46) so as to cut off a waveguide mode due to total reflection.

## Patentansprüche

1. Ein oberflächenemittierender Laser (1) mit:
eine Ausgabeeinheit (4) mit einer länglich geformten VCSEL-Struktur (vertical-cavity surface-emitting laser) (40), die einen unteren DBR (Distributed Bragg Reflector) (46), eine aktive Schicht (42) und einen oberen DBR (44) enthält; und
eine Ansteuerungsschaltung (5), die so strukturiert ist, dass sie einen Strom, der größer als ein Oszillationsschwellenwert ist, in die VCSEL-Struktur (40) injiziert, um einen Oszillationszustand auf der Grundlage der Verstärkungssättigung des VCSEL aufrechtzuerhalten,
wobei die Ausgabeeinheit (4) so strukturiert ist, dass sie ein kohärentes Keimlicht (L1) an ihrem einen Ende (3) der VCSEL-Struktur (40) empfängt, so dass sich das Keimlicht (L1) als langsames Licht durch die VCSEL-Struktur (40) in einer Längsrichtung ausbreitet, während es mehrfach in der VCSEL-Struktur (40) in einer vertikalen Richtung reflektiert wird, und so dass ein Ausgangslicht (L2) von einer oberen Oberfläche der VCSEL-Struktur (40) extrahiert wird, wobei eine Wellenlänge λ1 des Keimlichts (L1) und eine Wellenlänge λ2, die von der VCSEL-Struktur (40) der Ausgabeeinheit (4) bereitgestellt wird, ein Verhältnis λ1 ≠ λ2 erfüllen.

2. Oberflächenemittierender Laser (1) nach Anspruch 1, wobei eine Keimlichtquelle (2), die so strukturiert ist, dass sie das Keimlicht (L1) erzeugt, und die Ausgabeeinheit (4) in Längsrichtung nebeneinander integriert sind, wobei die Keimlichtquelle (2) eine VCSEL-Struktur (20) aufweist, die eine untere DBR (26), eine aktive Schicht (22) und eine obere DBR (24) enthält, und wobei die aktive Schicht (22) der Keimlichtquelle (2) und die aktive Schicht (42) der Ausgabeeinheit (4) nacheinander ausgebildet sind.

3. Oberflächenemittierender Laser (1) nach Anspruch 2, wobei eine Wellenlänge λ1 des Keimlichts (L1) und eine Wellenlänge λ2, die von der VCSEL-Struktur (40) der Ausgabeeinheit (4) bereitgestellt wird, ein Verhältnis λ1 < λ2 erfüllen.

4. Oberflächenemittierender Laser (1) nach Anspruch 2 oder 3, wobei die VCSEL-Struktur (20, 40) der Keimlichtquelle (2) und der Ausgabeeinheit (4) eine Luftspaltschicht umfasst,
und wobei die Luftspaltschicht auf der Seite der Keimlichtquelle so strukturiert ist, dass sie eine variable Dicke aufweist, die mit Hilfe einer mikrobearbeiteten Struktur gesteuert werden kann.

5. Oberflächenemittierender Laser (1) nach Anspruch 2 oder 3, wobei der obere DBR (44) der VCSEL-Struktur (40) der Ausgabeeinheit (4) so strukturiert ist, dass er eine größere Anzahl von Schichten aufweist als die des oberen DBR (24) der VCSEL-Struktur (20) der Keimlichtquelle (2).

6. Oberflächenemittierender Laser (1) nach Anspruch 2 oder 3, wobei ein Teil der Schichten, die die obere DBR (24) der VCSEL-Struktur (20) der Keimlichtquelle (2) bilden, mit einem niedrigen Brechungsindex ausgebildet sind, so dass die effektive Hohlraumlänge der Keimlichtquelle (20) reduziert ist, um das Verhältnis λ1 < λ2 für die Wellenlänge λ1 des Keimlichts (L1) und die Wellenlänge λ2, die von der VCSEL-Struktur (40) der Ausgabeeinheit (4) bereitgestellt wird, bereitzustellen.

7. Oberflächenemittierender Laser (1) nach Anspruch 2 oder 3, wobei die Keimlichtquelle (2) eine gekoppelte Resonanzstruktur aufweist.

8. Oberflächenemittierender Laser (1) nach einem der Ansprüche 1 bis 7, wobei die Ausgabeeinheit (4) zickzack-förmig gebogen ist.

9. Oberflächenemittierender Laser (1) nach Anspruch 1, wobei eine optische Begrenzungsschicht, die die aktive Schicht (42) der VCSEL-Struktur (40) bildet, so strukturiert ist, dass sie einen Brechungsindex aufweist, der kleiner ist als ein durchschnittlicher Brechungsindex des oberen DBR (44) und des unteren DBR (46), um einen Wellenleitermodus aufgrund von Totalreflexion zu unterbrechen.

## Revendications

1. Un laser à émission de surface (1) comprenant:
une unité de sortie (4) ayant une structure VCSEL (laser à cavité verticale émettant par la surface) de forme oblongue (40) comprenant un DBR (réflecteur de Bragg distribué) inférieur (46), une couche active (42) et un DBR supérieur (44); et
un circuit de commande (5) structuré pour injecter un courant supérieur à une valeur seuil d'oscillation dans la structure VCSEL (40) de manière à maintenir un état d'oscillation basé sur la saturation du gain du VCSEL, dans lequel l'unité de sortie (4) est structurée pour recevoir une lumière d'amorçage cohérente (L1) à son extrémité (3) de la structure VCSEL (40), de sorte que la lumière d'amorçage (L1) se propage comme une lumière lente à travers la structure VCSEL (40) dans une direction longitudinale tout en étant réfléchie plusieurs fois dans la structure VCSEL (40) dans une direction verticale, et de sorte qu'une lumière de sortie (L2) est extraite d'une surface supérieure de la structure VCSEL (40), dans lequel
une longueur d'onde λ1 de la lumière de départ (L1) et une longueur d'onde λ2 fournie par la structure VCSEL (40) de l'unité de sortie (4) satisfont à une relation 1λ ≠ λ2.

2. Laser à émission de surface (1) selon la revendication 1, dans lequel une source de lumière de semence (2) structurée pour générer la lumière de semence (L1) et l'unité de sortie (4) sont intégrées l'une à côté de l'autre dans la direction longitudinale, dans lequel la source de lumière de semence (2) a une structure VCSEL (20) comprenant un DBR inférieur (26), une couche active (22), et un DBR supérieur (24), et dans lequel la couche active (22) de la source de lumière de semence (2) et le lacer actif (42) de l'unité de sortie (4) sont formés successivement.

3. Laser à émission de surface (1) selon la revendication 2, dans lequel une longueur d'onde λ1 de la lumière d'amorçage (L1) et une longueur d'onde λ2 fournie par la structure VCSEL (40) de l'unité de sortie (4) satisfont à une relation λ1 < λ2.

4. Laser à émission de surface (1) selon la revendication 2 ou 3, dans lequel la structure VCSEL (20,40) de la source de lumière de départ (2) et de l'unité de sortie (4) comprend une couche d'entrefer,
et dans lequel la couche d'entrefer du côté de la source de lumière de semence est structurée de manière à avoir une épaisseur variable qui peut être contrôlée au moyen d'une structure micro-usinée.

5. Laser à émission de surface (1) selon la revendication 2 ou 3, dans lequel le DBR supérieur (44) de la structure VCSEL (40) de l'unité de sortie (4) est structuré de manière à avoir un plus grand nombre de couches que celles du DBR supérieur (24) de la structure VCSEL (20) de la source de lumière d'amorçage (2).

6. Laser à émission de surface (1) selon la revendication 2 ou 3, dans lequel une partie des couches qui forment le DBR supérieur (24) de la structure VCSEL (20) de la source de lumière de départ (2) est formée avec un faible indice de réfraction de sorte que la longueur effective de la cavité de la source de lumière de départ (20) est réduite pour assurer la relation λ₁ < λ₂ pour la longueur d'onde λ₁ de la lumière de départ (L1) et la longueur d'onde λ₂ fournie par la structure VCSEL (40) de l'unité de sortie (4).

7. Laser à émission de surface (1) selon la revendication 2 ou 3, dans lequel la source de lumière de départ (2) a une structure de résonance couplée.

8. Laser à émission de surface (1) selon l'une des revendications 1 à 7, dans lequel l'unité de sortie (4) est formée de manière à être pliée en zig-zag.

9. Laser à émission de surface (1) selon la revendication 1, dans lequel une couche de confinement optique qui forme la couche active (42) de la structure VCSEL (40) est structurée pour avoir un indice de réfraction qui est plus petit qu'un indice de réfraction moyen du DBR supérieur (44) et du DBR inférieur (46) de manière à couper un mode de guide d'ondes dû à la réflexion totale.
